# EUROPEAN PATENT APPLICATION

(11) **EP 2 492 974 A2**
(43) Date of publication of application: **29.08.2012**
(21) Application number: 11167415.6
(22) Date of filing: 25.05.2011
(51) Int. Cl.: H01L 33/12, H01L 33/00

(54) **Nitride based light emitting device using a buffer layer of wurtzite powder and method of manufacturing the same**

(30) Priority: 28.02.2011 KR 20110018229
(71) Applicant: Semimaterials Co., Ltd., Sengnam-si, Gyeonggi-do 463-400 (KR); Park, Kun, Bundang-gu Sengnam-si, Gyeonggi-do 463-440 (KR)
(72) Inventor: Park, Kun, 463-440 Gyeonggi-do (KR); Jin, Joo, 449-853, Gyeonggi-do (KR)
(74) Representative: Müller Schupfner & Partner

(57) **Abstract**

Disclosed is a nitride-based light emitting device using powders of a material having a Wurtzite lattice structure, such as ZnO powders. The nitride-based light emitting device includes a growth substrate, a lattice buffer layer formed on the growth substrate, and a light emitting structure formed on the lattice buffer layer and having a plurality of nitride layers stacked therein, wherein the lattice buffer layer is formed of powders of a material having a Wurtzite lattice structure. The lattice buffer layer is formed of ZnO powders, thereby minimizing occurrence of dislocations caused by a difference in lattice constant between a nitride layer and the growth substrate during growth of the nitride layer. A method of manufacturing the same is also disclosed.

## Description

### 1. Technical Field

The present invention relates to a technique for manufacturing nitride-based light emitting devices.

### 2. Description of the Related Art

A light emitting device is a semiconductor device based on a luminescence phenomenon occurring upon recombination of electrons and holes in the device.

For example, nitride-based light emitting devices such as GaN light emitting devices are widely used. The nitride-based light emitting devices can realize a variety of colors due to high band-gap energy thereof. Further, the nitride-based light emitting devices exhibit excellent thermal stability.

The nitride-based light emitting devices may be classified into a lateral type and a vertical type according to arrangement of an n-electrode and a p-electrode therein. The lateral type structure generally has a top-top arrangement of the n-electrode and the p-electrode and the vertical type structure generally has a top-bottom arrangement of the n-electrode and the p-electrode.

In the related art, a sapphire substrate is generally used as a growth substrate when manufacturing a nitride-based light emitting device.

However, the sapphire substrate has negative thermal characteristics. Thus, if the sapphire substrate is used as the growth substrate, wafer bowing, wherein the substrate is bows upon nitride growth at high temperature, occurs.

Further, if the sapphire substrate is used as a growth substrate, it is difficult to manufacture a vertical type light emitting device due to insulating characteristics thereof.

On the other hand, a growth substrate is much cheaper than the sapphire substrate and has excellent thermal and electrical characteristics. However, in manufacture of the nitride-based light emitting device, the growth substrate is not frequently adopted as a growth substrate. This is because many dislocations are created in a growing nitride layer due to a large difference in lattice constant between the growth substrate and the nitride layer when growing the nitride layer on the growth substrate. Such dislocations have an adverse influence on electrical characteristics of the nitride-based light emitting device.

### BRIEF SUMMARY

One aspect of the present invention is to provide a nitride-based light emitting device and a method of manufacturing the same, which can enhance crystallinity and brightness by suppressing occurrence of dislocations upon growth of a nitride layer on a growth substrate.

In accordance with one aspect of the invention, a nitride-based light emitting device includes: a growth substrate; a lattice buffer layer formed on the growth substrate; and a light emitting structure formed on the lattice buffer layer and having a plurality of nitride layers stacked therein. Here, the lattice buffer layer is formed of powders of a material having a Wurtzite lattice structure.

The lattice buffer layer may be formed of ZnO powders.

In accordance with another aspect of the invention, a method of manufacturing a nitride-based light emitting device includes: forming a lattice buffer layer on a growth substrate using powders of a material having a Wurtzite lattice structure; and forming a light emitting structure by sequentially growing a plurality of nitride layers on the lattice buffer layer.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic sectional view of a nitride-based light emitting device according to an exemplary embodiment of the present invention;
Fig. 2 is a flowchart of a method of manufacturing a nitride-based light emitting device according to an exemplary embodiment of the present invention; and
Fig. 3 is a scanning electron microscope (SEM) image showing air holes formed by etching a ZnO layer during growth of a nitride layer.

### DETAILED DESCRIPTION

Exemplary embodiments of the invention will now be described in detail with reference to the accompanying drawings.

It will be understood that when an element such as a layer, film, region or substrate is referred to as being "on" another element, it can be directly on the other element or intervening elements may also be present. In contrast, when an element is referred to as being "directly on" another element, there are no intervening elements present.

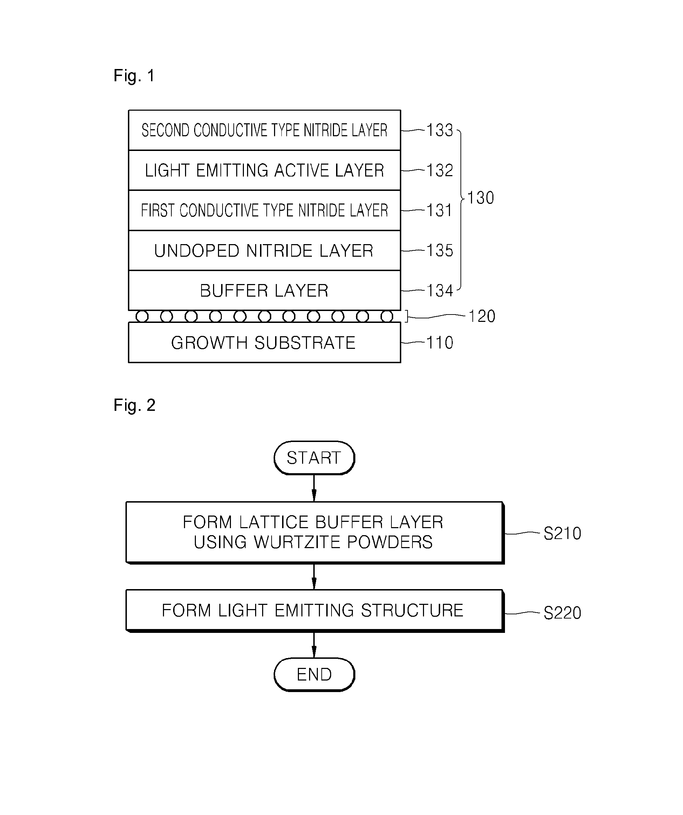

Fig. 1 is a schematic sectional view of a nitride-based light emitting device according to an exemplary embodiment of the present invention.

Referring to Fig. 1, the nitride-based light emitting device includes a growth substrate 110, a lattice buffer layer 120, and a light emitting structure 130.

In this embodiment, the growth substrate 110 may be a sapphire substrate which is widely used as a growth substrate in manufacture of nitride-based light emitting devices. Further, in this embodiment, the growth substrate 110 may be a silicon substrate such as a single crystal silicon substrate, a polycrystal silicon substrate, and the like.

Conventionally, when growing a nitride layer on the growth substrate, many dislocations are generated due to lattice mismatch between the growth substrate and the nitride layer. The dislocations cause reduction in luminous efficacy of a nitride-based light emitting device.

Therefore, according to the present invention, the lattice buffer layer 120 is first grown on the growth substrate 110 and a nitride layer is then grown thereon to minimize such lattice mismatch.

The lattice buffer layer 120 is formed on the growth substrate 110. The lattice buffer layer 120 may be formed of a material that relieves lattice mismatch with a nitride layer to be grown thereon, thereby suppressing occurrence of dislocations during growth of the nitride layer. As a result, it is possible to improve crystallinity of the nitride layer growing on the growth substrate.

For example, when a silicon substrate is used as the growth substrate, dislocation density increases to a great extent during growth of the nitride layer on the silicon substrate due to a great difference in lattice constant between the silicon substrate and a nitride layer, thereby causing deterioration in luminescence efficiency. However, when the lattice buffer layer is formed on the silicon layer and the nitride layer is then formed on the lattice buffer layer, lattice mismatch between the nitride layer and the substrate is relieved, thereby reducing dislocation density caused by lattice mismatch during growth of the nitride layer.

The lattice buffer layer 120 may be formed of powders of a material having the Wurtzite lattice structure.

More preferably, the lattice buffer layer may be formed using ZnO powders.

For example, ZnO widely used in manufacture of nitride-based light emitting devices has a Wurtzite lattice structure, and lattice constants of a=3.189Å and c=5.185Å.

ZnO also has a Wurtzite lattice structure like GaN. Further, ZnO has lattice constants of a=3.249Å and c=5.207Å, so that ZnO has a very similar lattice structure to GaN.

Thus, when growing GaN on ZnO powders, lattice match can occur therebetween, thereby minimizing occurrence of dislocations. Further, when growing GaN on the ZnO powders, the GaN is initially grown in the vertical direction and then grows in the horizontal direction, thereby enabling growth of a flat GaN layer.

The ZnO powders may be attached or secured to the growth substrate 110 by spin coating, or the like.

To allow the ZnO powders to be easily attached or secured to the growth substrate 110, the growth substrate 110 may have an uneven surface formed with prominences and depressions. The surface unevenness may be formed as a specific or random pattern. The surface unevenness of the growth substrate 110 may be formed by various methods such as etching or the like.

When the growth substrate 110 has the uneven surface, the ZnO powders may be easily attached or secured to the depressions on the growth substrate 110.

The ZnO powders used for the lattice buffer layer 120 may have an average particle size of 10 nm ∼ 1 µm. The smaller the average particle size of the powders, the better the effect of suppressing generation of the dislocations during nitride growth. If the average particle size of ZnO powders exceeds 1 µm, the effect of suppressing generation of dislocations is insufficient, causing low luminescence efficiency of the manufactured nitride-based light emitting device. If the average particle size of ZnO powders is less than 10 nm, manufacturing costs of the ZnO powders are excessively increased, thereby causing an increase in manufacturing costs of the nitride-based light emitting device.

Next, the light emitting structure 130 is formed on the lattice buffer layer 120.

The light emitting structure 130 is formed by stacking a plurality of nitride layers one above another.

More specifically, the light emitting structure 130 includes a first conductive type nitride layer 131, a light emitting active layer 132, and a second conductive type nitride layer 133.

The first conductive type nitride layer 131 is formed on the lattice buffer layer 120.

The first conductive type nitride layer 131 may exhibit characteristics of an n-type or p-type semiconductor according to impurities doped thereto. For example, if the first conductive type nitride layer 131 is formed by doping an n-type impurity such as silicon (Si) into a nitride layer, the first conductive type nitride layer 131 exhibits characteristics of the n-type semiconductor. On the other hand, if the first conductive type nitride layer 131 is formed by doping a p-type impurity such as magnesium (Mg) into a nitride layer, the first conductive type nitride layer 131 exhibits characteristics of the p-type semiconductor.

The light emitting active layer 132 is formed on the first conductive type nitride layer 131. The light emitting active layer 132 may have a multiple quantum well (MQW) structure. For example, the light emitting active layer 132 may have a structure having InₓGa₁₋ₓN (0.1≤x≤0.3) and GaN alternately stacked one above another.

In the light emitting active layer 132, electrons traveling through the n-type nitride layer recombine with holes traveling through the p-type nitride layers to generate light.

The second conductive type nitride layer 133 is formed on the light emitting active layer 132 and exhibits opposite electrical characteristics to those of the first conductive type nitride layer 132.

For example, if the first conductive type nitride layer 131 is an n-type GaN layer, the second conductive type nitride layer 133 may be a p-type GaN layer. The n-type GaN layer may be formed by doping Si into a GaN layer and the p-type GaN layer may be formed by doping Mg into the GaN layer.

As such, if the first conductive type nitride layer 131 is the n-type GaN layer and the second conductive type nitride layer 133 is the p-type GaN layer, an n-type silicon substrate may be adopted as the growth substrate 110. When the n-type silicon substrate is adopted, n-type semiconductor layers may be formed as the respective layers under the light emitting active layer 132. In addition, when the n-type silicon substrate is adopted, the growth substrate may be used as an n-electrode. Thus, it is possible to eliminate a lift-off process for removing the growth substrate and a process of forming an n-electrode even in manufacture of a vertical type light emitting device.

Accordingly, when adopting the n-type silicon substrate, it is possible to easily fabricate not only the lateral type light emitting device but also the vertical type light emitting device which has a relatively wide light emitting area to easily realize high brightness light emission.

In addition, when the n-type silicon substrate is used as the growth substrate, the growth substrate is subjected to insignificant bowing during nitride growth at high temperature, thereby enabling uniform growth of the nitride layer.

The light emitting structure 130 may further include a buffer layer 134 on the lattice buffer layer 120. In this case, the first conductive type nitride layer 131 is formed on the buffer layer 134.

The buffer layer 134 serves to relieve stress generated during growth of the nitride layer, which is a hetero-material, on the growth substrate. The buffer layer 134 may be formed of a nitride material such as AlN, ZrN, GaN, and the like.

If the first conductive type nitride layer 131 is an n-type nitride layer, the buffer layer 134 may also be an n-type nitride layer. Nitrides for the buffer layer 134 generally have high electric resistance. However, if the buffer layer 134 is the n-type layer, the buffer layer has low electric resistance. Accordingly, it is possible to improve operational efficiency of the nitride-based light emitting device.

Meanwhile, ZnO exhibit electrical characteristics of an n-type layer. Thus, if an n-type silicon substrate is used as the growth substrate 110 and the buffer layer 134 and the first conductive type nitride layer 131 are n-type layers, electrons injected into the silicon substrate can easily reach the light emitting active layer 132 without interference of a barrier. Accordingly, it is possible to further improve operational efficiency of the light emitting device.

Further, an undoped nitride layer 135 may be formed on the buffer layer 134 to further facilitate lattice-matching. In this case, the first conductive type nitride layer 131 is formed on the undoped nitride layer 135. The undoped nitride layer 135 is preferably used with an undoped substrate.

Fig. 2 is a flowchart of a method of manufacturing a nitride-based light emitting device according to an exemplary embodiment of the present invention.

Referring to Fig. 2, the method of manufacturing a nitride-based light emitting device includes forming a lattice buffer layer in operation S21 0 and forming a light emitting structure in operation S220.

In operation S21 0, the lattice buffer layer is formed on a growth substrate such as a silicon substrate or a sapphire substrate using powders of a material having a Wurtzite lattice structure.

Here, the lattice buffer layer may be formed of ZnO powders.

Here, the ZnO powders may be prepared by depositing ZnO on a substrate such as a silicon substrate or a sapphire substrate, more preferably, a substrate made of the same material as the growth substrate, and pulverizing the ZnO deposited substrate into powders. Deposition of ZnO may be carried out by MOCVD or sputtering. In this case, since the ZnO powders contain not only pure ZnO components but also components of the substrate, adhesion of the ZnO powders to the growth substrate may be improved.

The lattice buffer layer may be formed using the ZnO powders in the following manner.

First, ZnO powders are coated on the growth substrate using a spin coater or the like. Then, the growth substrate is heated to about 500∼800°C in a nitrogen atmosphere in a chamber, for example a CVD chamber, such that the ZnO powders are attached to the growth substrate. Since the ZnO powders can be etched at an excessively high heating temperature, it is advantageous that the process is carried out at a temperature of 800°C or less. In this case, the growth substrate may be slightly etched to form an uneven surface. The surface unevenness of the growth substrate facilitates attachment or securing of the ZnO powders thereto, as described above.

Alternatively, the lattice buffer layer may be formed using a ZnO powder-containing solution by spin-coating the solution on the growth substrate and drying the growth substrate. Here, the solution containing the ZnO powders may be prepared using various solvents, such as acetone, methanol, ethylene glycol, and the like.

Either or both of the methods described above may be selectively used to form the lattice buffer layer. For example, the lattice buffer layer may be formed by spin-coating the ZnO powder-containing solution on the growth substrate and drying the substrate, followed by heating the growth substrate in a chamber.

Next, in the operation of forming the light emitting structure, the light emitting structure is formed by sequentially growing a plurality of nitride layers on the lattice buffer layer.

The light emitting structure is formed by sequentially stacking a first conductive nitride layer, a light emitting active layer, and a second conductive type nitride layer one above another. In some embodiments, a buffer layer or an undoped nitride layer may further be formed before the first conductive type nitride layer is formed.

Here, among the plurality of nitride layers for the light emitting structure, the first nitride layer (for example, buffer layer) on the lattice buffer layer may be formed in an inert gas atmosphere, such as helium (He) gas, argon (Ar) gas, and the like. When the first nitride layer is formed in a hydrogen atmosphere, the ZnO powders are etched by hydrogen gas, so that the buffer layer cannot be sufficiently formed.

Further, additional nitride layers may be formed in a hydrogen atmosphere to have improved crystal quality. In this case, since the first nitride layer has already been formed, the additional nitride layers are not affected by etching of the ZnO powders even in the hydrogen atmosphere when forming the additional nitride layers on the first nitride layer.

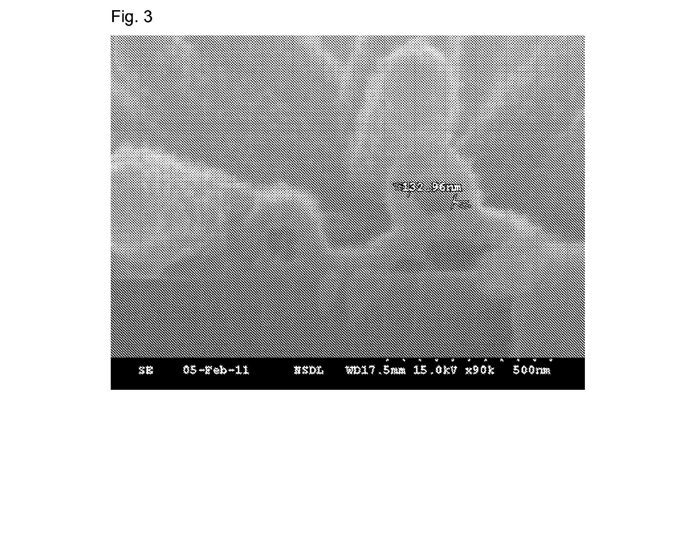

Further, when the nitride layers are formed in the hydrogen atmosphere except for the first nitride layer, some or all of the ZnO powders are etched to form air holes between the growth substrate and the first nitride layer, as in an example shown in Fig. 3. Such air holes serve as an irregular reflection layer, thereby improving brightness of the nitride-based light emitting device.

As set forth above, in the method of manufacturing a nitride-based light emitting device according to the embodiments, a lattice buffer layer is formed using powders of a material having the Wurtzite lattice structure, such as ZnO powders, on a growth substrate and a nitride layer such as GaN is then grown thereon. As a result, it is possible to suppress occurrence of dislocations caused by lattice mismatch between the nitride layer and the growth substrate during growth of the nitride layer. Accordingly, the method according to the embodiments may improve crystallinity and brightness of the nitride-based light emitting device manufactured thereby.

As such, in the method of manufacturing a nitride-based light emitting device according to the embodiments of the invention, powders of a material having the Wurtzite lattice structure, such as ZnO powders, are coated on a growth substrate and a nitride layer such as GaN is then grown thereon. As a result, it is possible to suppress occurrence of dislocations caused by a difference in lattice constant between the nitride layer and the growth substrate during growth of the nitride layer.

Further, the method of manufacturing a nitride-based light emitting device according to the embodiments of the invention may employ an n-type silicon substrate growth substrate. In this case, it is possible to eliminate a lift-off process for removing the n-type silicon substrate in manufacture of a vertical type light emitting device.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A nitride-based light emitting device including a light emitting structure on a growth substrate, **characterized by** comprising:
a growth substrate;
a lattice buffer layer formed on the growth substrate; and
a light emitting structure formed on the lattice buffer layer and having a plurality of nitride layers stacked therein,
the lattice buffer layer being formed of powders of a material having a Wurtzite lattice structure.

2. The nitride-based light emitting device of claim 1, **characterized in that** the lattice buffer layer is formed of ZnO powders.

3. The nitride-based light emitting device of claim 2, **characterized in that** the ZnO powders have an average particle size of 10 nm to 1 µm.

4. The nitride-based light emitting device of claim 1, **characterized in that** the growth substrate is a silicon substrate or a sapphire substrate.

5. The nitride-based light emitting device of claim 1, **characterized in that** the growth substrate has an uneven surface.

6. The nitride-based light emitting device of claim 1, **characterized in that** the light emitting structure comprises:
an n-type nitride layer formed on the lattice buffer layer;
a light emitting active layer formed on the n-type nitride layer; and
a p-type nitride layer formed on the light emitting active layer.

7. The nitride-based light emitting device of claim 6, **characterized in that** the growth substrate is an n-type silicon substrate.

8. The nitride-based light emitting device of claim 6, **characterized in that** the light emitting device further comprises a buffer layer formed of a nitride between the lattice buffer layer and the n-type nitride layer.

9. The nitride-based light emitting device of claim 8, **characterized in that** the buffer layer is formed of at least one nitride selected from AlN, ZrN, and GaN.

10. The nitride-based light emitting device of claim 8, **characterized in that** the buffer layer is formed of an n-type nitride.

11. The nitride-based light emitting device of claim 8, **characterized in that** the light emitting structure further comprises an undoped nitride layer between the buffer layer and the n-type nitride layer.

12. A method of manufacturing a nitride-based light emitting device including a light emitting structure on a growth substrate, **characterized by** comprising:
forming a lattice buffer layer on a growth substrate using powders of a material having a Wurtzite lattice structure; and
forming a light emitting structure by sequentially forming a plurality of nitride layers on the lattice buffer layer.

13. The method of claim 12, **characterized in that** the lattice buffer layer is formed of ZnO powders.

14. The method of claim 13, **characterized in that** the ZnO powders are prepared by depositing ZnO on a silicon or sapphire substrate and pulverizing the ZnO-deposited substrate into powders.

15. The method of claim 13, **characterized in that** the forming the light emitting structure comprises:
forming a first nitride layer on the lattice buffer layer formed of the ZnO powders in an inert gas atmosphere; and
forming additional nitride layers on the first nitride layer in a hydrogen atmosphere,
some or all of the ZnO powders being etched to form air holes between the growth substrate and the first nitride layer when forming the additional nitride layers.
